# EUROPEAN PATENT APPLICATION

(11) **EP 4 216 284 A1**
(43) Date of publication of application: **26.07.2023**
(21) Application number: 21869053.5
(22) Date of filing: 02.08.2021
(51) Int. Cl.: H01L 31/043

(54) **SOLAR CELL AND SOLAR CELL SYSTEM**

(30) Priority: 17.09.2020 WO PCT/JP2020/035259
(71) Applicant: KABUSHIKI KAISHA TOSHIBA, Minato-ku Tokyo 105-0023 (JP); Toshiba Energy Systems & Solutions Corporation, Saiwai-ku Kawasaki-shi Kanagawa 2120013 (JP)
(72) Inventor: SHIOKAWA Miyuki, Kawasaki-shi, Kanagawa 212-0013 (JP); YAMASHITA Katsuya, Kawasaki-shi, Kanagawa 212-0013 (JP); TOBARI Tomohiro, Kawasaki-shi, Kanagawa 212-0013 (JP); GOTANDA Takeshi, Kawasaki-shi, Kanagawa 212-0013 (JP); SAITA Yutaka, Kawasaki-shi, Kanagawa 212-0013 (JP)
(74) Representative: AWA Sweden AB
(86) International application number: PCT/JP2021/028595
(87) International publication number: WO 2022/059366

(57) **Abstract**

A solar cell includes a top cell module that generates power by photoelectrically converting incident light and allows part of the incident light to pass through the top cell module, and a bottom cell module that is laminated to the top cell module and generates power by photoelectrically converting light that has passed through the top cell module, wherein the top cell module includes a plurality of top cells that are connected in series, in parallel, or in a combination of series and parallel, the bottom cell module includes a plurality of bottom cells that are connected in series, in parallel, or in a combination of series and parallel, the number of the bottom cells being equal to the number of the top cells, and an electrode connecting the plurality of top cells is positioned such that the electrode does not overlap the bottom cells in plan view.

## Description

### [Technical Field]

Embodiments of the present invention relate to a solar cell and a solar cell system.

### [Background Art]

A tandem solar cell including a top cell module and a bottom cell module is known in the related art. A tandem solar cell can efficiently generate power in a small area by combining a top cell module and a bottom cell module formed of materials having different light absorption bands.

### [Citation List]

### [Patent Document]

[Patent Document 1]
   Japanese Unexamined Patent Application, First Publication No. 2020-53669
[Patent Document 2]
   Published Japanese Translation No. 2017-534184 of the PCT International Publication

### [Summary of Invention]

### [Technical Problem]

In the tandem solar cell, it is assumed that the top cell module includes a plurality of top cells and the bottom cell module includes a plurality of bottom cells. However, in the technology of the related art, electrodes connecting a plurality of top cells may overlap bottom cells in plan view, resulting in a decrease in the amount of power generated by the bottom cells.

It is an object of the present invention to provide a solar cell and a solar cell system capable of limiting a decrease in the amount of power generated by bottom cells.

### [Solution to Problem]

A solar cell of an embodiment includes a top cell module and a bottom cell module. The top cell module generates power by photoelectrically converting incident light and allows part of the incident light to pass through the top cell module. The bottom cell module is laminated to the top cell module and generates power by photoelectrically converting light that has passed through the top cell module. The top cell module includes a plurality of top cells that are connected in series, in parallel, or in a combination of series and parallel. The bottom cell module includes a plurality of bottom cells that are connected in series, in parallel, or in a combination of series and parallel, the number of the bottom cells being equal to the number of the top cells. An electrode connecting the plurality of top cells is positioned such that the electrode does not overlap the bottom cells in plan view.

### [Brief Description of Drawings]

FIG. 1 is a configuration diagram of a solar cell 1 according to a first embodiment.
FIG. 2 is a view of a configuration of a top cell module 100 viewed in a Z direction.
FIG. 3 is a perspective view showing an example of a laminated structure of each top cell 110.
FIG. 4 is a side view showing an example of the laminated structure of the top cell 110.
FIG. 5 is an equivalent circuit diagram of the top cell module 100.
FIG. 6 is a (first) view of a configuration of a bottom cell module 200 viewed in the Z direction.
FIG. 7 is a (first) view of the configuration of the bottom cell module 200 viewed in a Y direction.
FIG. 8 is a (second) view of a configuration of a bottom cell module 200 viewed in the Z direction.
FIG. 9 is a (second) view of the configuration of the bottom cell module 200 viewed in the Y direction.
FIG. 10 is an equivalent circuit diagram of the bottom cell module 200.
FIG. 11 is a configuration diagram of a solar cell system according to the first embodiment.
FIG. 12 is a configuration diagram of a solar cell 2 of a second embodiment.
FIG. 13 is a configuration diagram of a solar cell system according to the second embodiment.
FIG. 14 is a plan view of the solar cell 1 or 2.
FIG. 15 is a cross-sectional view along line 15-15 of FIG. 14.

### [Description of Embodiments]

A solar cell and a solar cell system according to embodiments will be described below with reference to the drawings.

### First embodiment

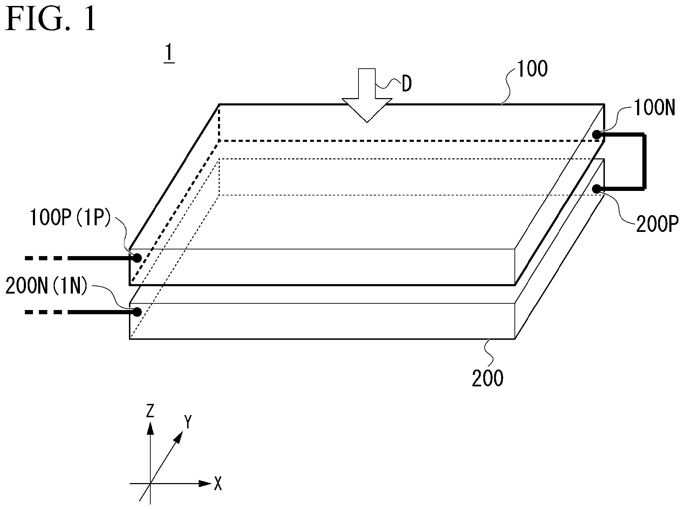

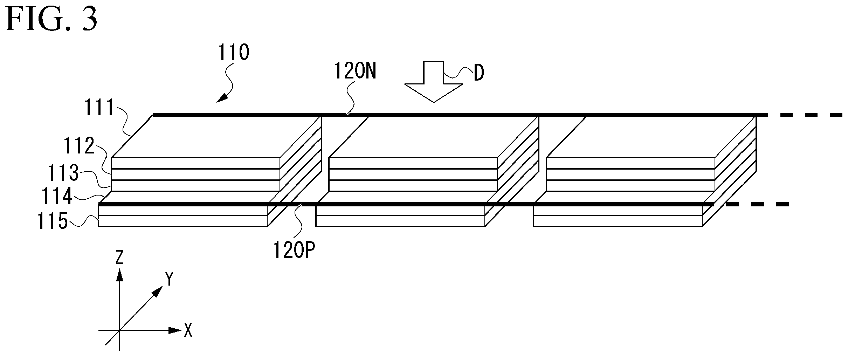

FIG. 1 is a configuration diagram of a solar cell 1 according to a first embodiment. The solar cell 1 includes a top cell module 100 and a bottom cell module 200. Each of the top cell module 100 and the bottom cell module 200 has, for example, a flat plate shape having a rectangular surface and the top cell module 100 and the bottom cell module 200 are stacked in the thickness direction. Hereinafter, the extending direction of one side of the rectangular surface of each of the top cell module 100 and the bottom cell module 200 is defined as an X direction, the extending direction of another side thereof is defined as a Y direction, and the thickness direction is defined as a Z direction. An arrow D in FIG. 1 indicates the direction of incidence of light (sunlight). The same applies to FIGS. 3, 4, 7, 9 and 11 which will be described later. The solar cell 1 is installed such that light is incident on the rectangular surface of the top cell module 100 on the side opposite to the bottom cell module 200.

The top cell module 100 generates power by photoelectrically converting incident light while allowing part of the incident light to pass through the top cell module 100. The bottom cell module 200 generates power by photoelectrically converting light that has passed through the top cell module 100. A positive terminal 100P of the top cell module 100 doubles as a positive terminal 1P of the solar cell 1. A negative terminal 100N of the top cell module 100 is connected to a positive terminal 200P of the bottom cell module 200. A negative terminal 200N of the bottom cell module 200 doubles as a negative terminal 1N of the solar cell 1. Thus, in the first embodiment, the top cell module 100 and the bottom cell module 200 are connected in series between the positive terminal 1P and the negative terminal 1N of the solar cell 1.

The top cell module 100 includes a plurality of top cells 110 (shown later) that are connected in series, in parallel, or in a combination of series and parallel and the bottom cell module 200 includes a plurality of bottom cells 210 (shown later) that are connected in series, in parallel, or in a combination of series and parallel. As will be described later, the connection mode of the plurality of top cells 110 and the connection mode of the plurality of bottom cells 210 may be set to match the current ratio between a top cell 110 and a bottom cell 210. The current ratio is the ratio between power generated by a top cell 110 and power generated by a bottom cell 210 when light of an assumed component is incident. Hereinafter, the current ratio (top cell output current:bottom cell output current) is expressed as 1:α. α>1 since the bottom cell 210 normally outputs more current.

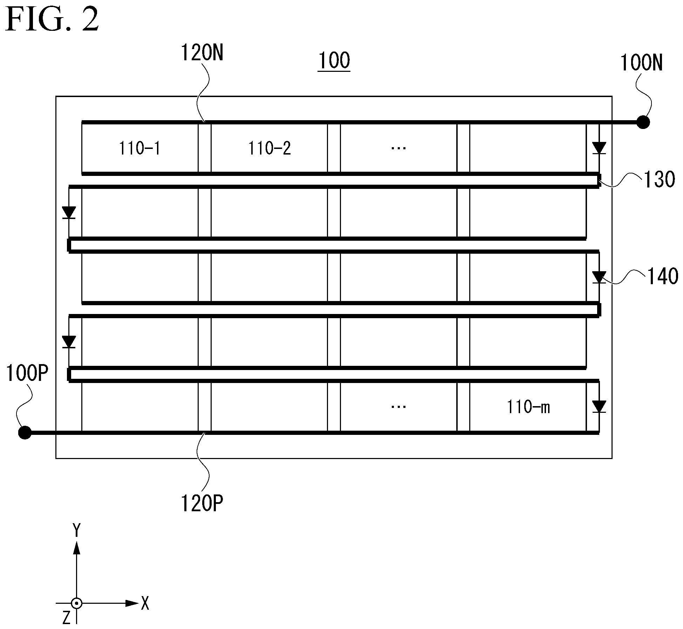

FIG. 2 is a view of a configuration of the top cell module 100 viewed in the Z direction. The top cell module 100 includes, for example, a plurality of top cells 110-1 to m, positive-side cell interconnectors 120P, negative-side cell interconnectors 120N, string connectors 130, and diodes 140. m is an arbitrary natural number equal to or greater than 2 and m = 20 in FIG. 2. Each top cell will be simply referred to as a top cell 110 when there is no distinction as to which top cell it is. Each negative-side cell interconnector 120N is a conductor that commonly connects n-electrodes 111 (shown later) of top cells 110 arranged in the X direction. Each positive-side cell interconnector 120P is a conductor that commonly connects p-electrodes 114 (shown later) of the top cells 110 arranged in the X direction. Thus, in the configuration of FIG. 2, four top cells 110 are connected in parallel. Each diode 140 is a bypass diode provided for every four top cells 110 connected in parallel. Each diode 140 bypasses a current flowing through corresponding four top cells 110 when the corresponding four top cells 110 are shaded or fail. The top cell module 100 is joined to the bottom cell module 200 via a resin containing a sealing material, an adhesive film, or the like.

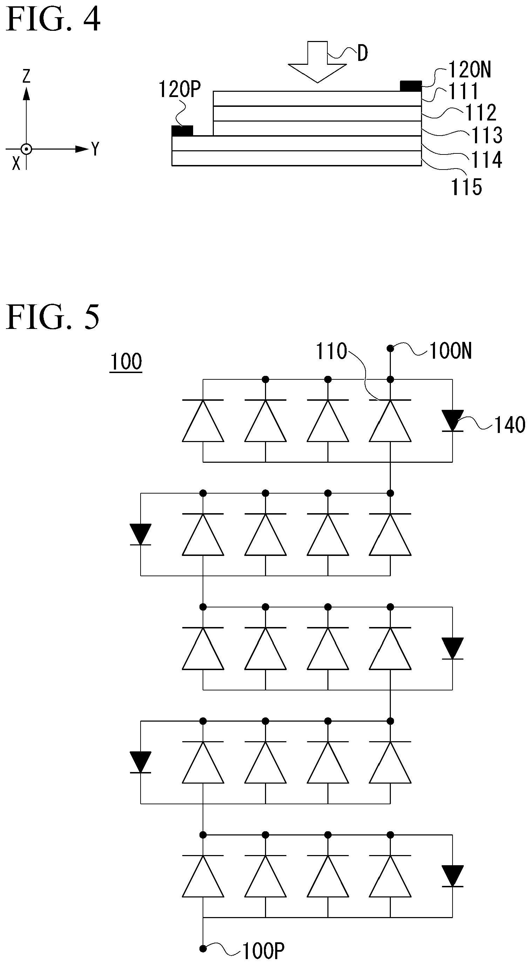

FIG. 3 is a perspective view showing an example of a laminated structure of each top cell 110. FIG. 4 is a side view showing an example of the laminated structure of the top cell 110. The top cell 110 is, for example, a cuprous oxide solar cell and has, for example, a configuration in which an n-electrode 111, an n-compound layer 112, a p-light absorbing layer 113, a p-electrode 114, and a substrate 115 are laminated in order from the negative-side cell interconnector 120N side. The configuration shown in FIGS. 3 and 4 is merely an example and any configuration can be adopted as long as it is a configuration capable of generating power by photoelectrically converting incident light while allowing part of the incident light to pass therethrough. For example, a cuprous oxide (Cu₂O) solar cell, a dye-sensitized solar cell, an organic thin film solar cell, or a perovskite solar cell is adopted as the top cell 110. A protective film, a sealing material, and the like may be appropriately added to the configuration shown in FIGS. 3 and 4. An antireflection film may be formed on the n-compound layer 112 for the purpose of facilitating introduction of light into the power generation layer. The n-electrode 111 and the p-electrode 114 are, for example, transparent conductive films or electrodes formed in a mesh shape and allow light to pass through gaps of the mesh. The substrate 115 is, for example, a transparent film of such as glass or PET, and the higher the light transmittance, the better. The top cell 110 generates a voltage between the n-compound layer 112 and the p-light absorbing layer 113. The generated voltage becomes a voltage between the n-electrode 111 and the p-electrode 114 and this voltage is extracted by the negative-side cell interconnector 120N and the positive-side cell interconnector 120P. FIG. 5 is an equivalent circuit diagram of the top cell module 100. As shown, the top cell module 100 has a circuit configuration in which top cells 110 are connected in a four-in-parallel, five-in-series configuration.

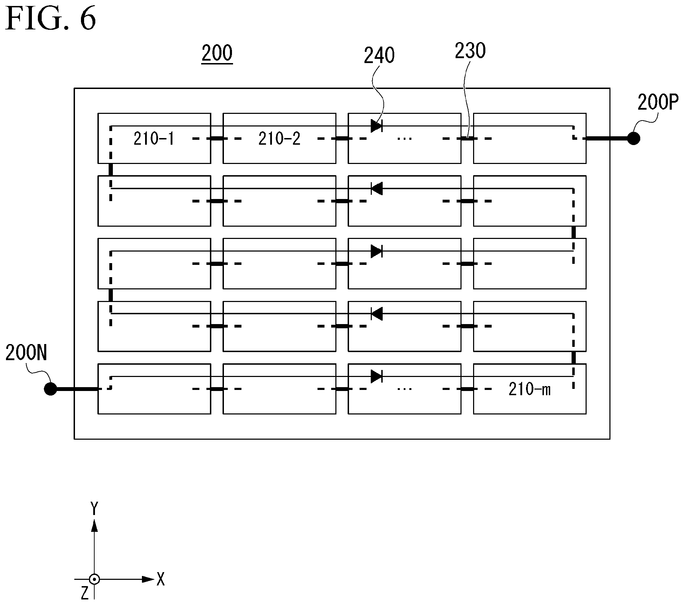

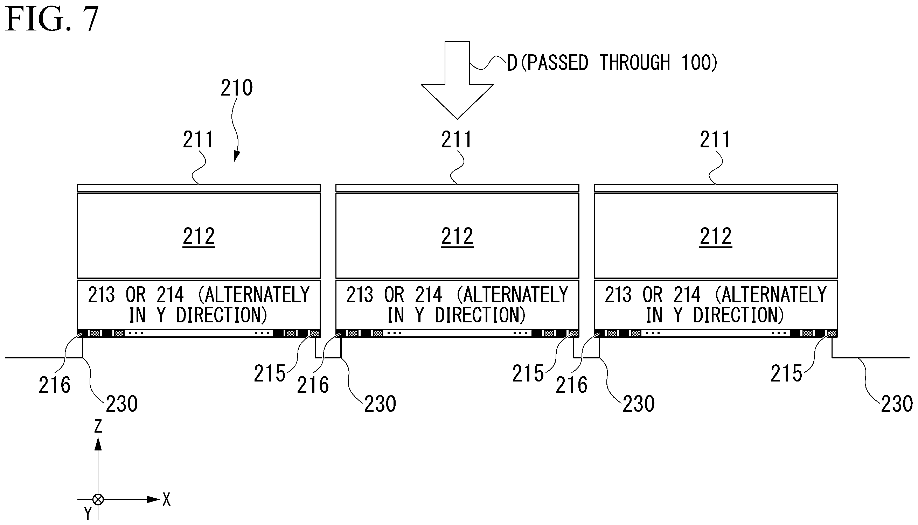

Each bottom cell 210 is, for example, a back-contact solar cell. An exemplary configuration in this case is shown in FIGS. 6 and 7. FIG. 6 is a (first) view of a configuration of the bottom cell module 200 viewed in the Z direction. The bottom cell module 200 includes, for example, a plurality of bottom cells 210-1 to m, cell interconnectors 230, and diodes 240. Each bottom cell will be simply referred to as a bottom cell 210 when there is no distinction as to which bottom cell it is. The cell interconnectors 230 are conductors that are provided between adjacent bottom cells 210 and connect the m bottom cells 210 in series. Each diode 240 is a bypass diode provided for every four bottom cells 210 connected in series. Each diode 240 bypasses a current flowing through corresponding four bottom cells 210 when the corresponding four bottom cells 210 are shaded or fail.

FIG. 7 is a (first) view of the configuration of the bottom cell module 200 viewed in the Y direction. As shown, each bottom cell 210 includes, for example, an antireflection film 211, an n-type semiconductor 212, and a p+ diffusion layer 213 or an n+ diffusion layer 214 that are laminated in order from the top cell module 100 side. The p+ diffusion layers 213 and the n+ diffusion layers 214 are alternately arranged in the Y direction of the bottom cells 210. A protective film, a sealing material, and the like may be appropriately added to the configuration shown in FIG. 7. The bottom cell 210 generates a voltage between the p+ diffusion layer 213 and the n+ diffusion layer 214. The generated voltage becomes voltages between p-electrodes 215 and n-electrodes 216. The p-electrodes 215 and the n-electrodes 216 are also alternately arranged in the Y direction. A plurality of p-electrodes 215 in each bottom cell 210 are grouped together and a plurality of n-electrodes 216 in each bottom cell 210 are also grouped together. Both voltages of each bottom cell 210 are connected to electrodes of the opposite n or p type of its adjacent bottom cells 210 through the cell interconnectors 230, such that the bottom cells 210 are connected in series.

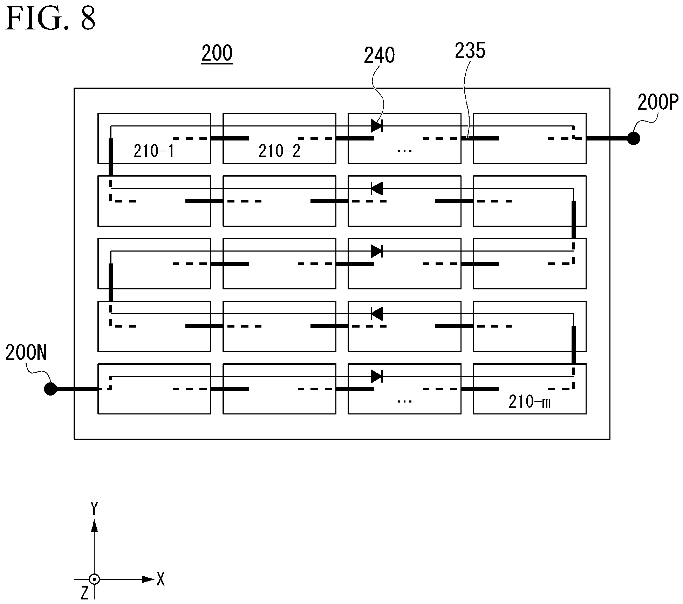

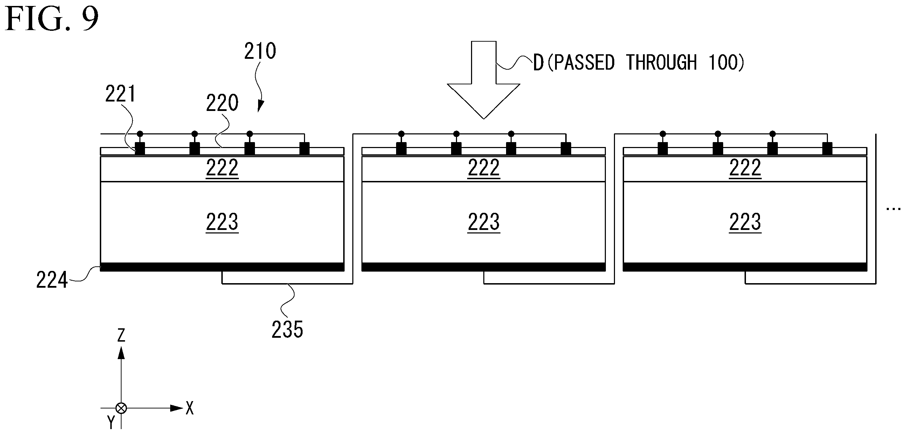

The bottom cell 210 may be a solar cell of other modes such as a crystalline Si solar cell. An exemplary configuration in this case is shown in FIGS. 8 and 9. FIG. 8 is a (second) view of a configuration of a bottom cell module 200 viewed in the Z direction. Cell interconnectors 235 in this example are conductors that connect the m bottom cells 210 in series by connecting a front surface (the front side in FIG. 8) and a back surface (the back side in FIG. 8) of adjacent bottom cells 210.

FIG. 9 is a (second) view of the configuration of the bottom cell module 200 viewed in the Y direction. As shown, each bottom cell 210 includes, for example, n-electrodes 221, an antireflection film 220, an n-type semiconductor 222, a p-type semiconductor 223, and a p-electrode 224 that are laminated in order from the top cell module 100 side. The bottom cell 210 generates a voltage between the p-type semiconductor 223p and the n-type semiconductor 222. The generated voltage becomes a voltage between the p-electrode 224 and the n-electrodes 221. This voltage is boosted and extracted by connecting the bottom cells 210 in series through the cell interconnectors 235. Other examples of the bottom cell module 200 include monocrystalline, polycrystalline, heterojunction, and amorphous silicon-based solar cells, and CIS-based and CIGS-based compound solar cells and the cell electrode (p-electrode, n-electrode) structure may be combined with a metal wrap through structure or a double-sided light-receiving structure. The metal wrap through structure is an electrode structure in which n-electrodes 221 extend through the bottom cell 210 in the thickness direction and reach the back surface thereof in the structure shown in FIG. 9. The double-sided light-receiving structure is an electrode structure in which p-electrodes 224 are wired through a bus bar like the n-electrodes 221, rather than being arranged over the entire back surface of the bottom cell 210, in the structure shown in FIG. 9.

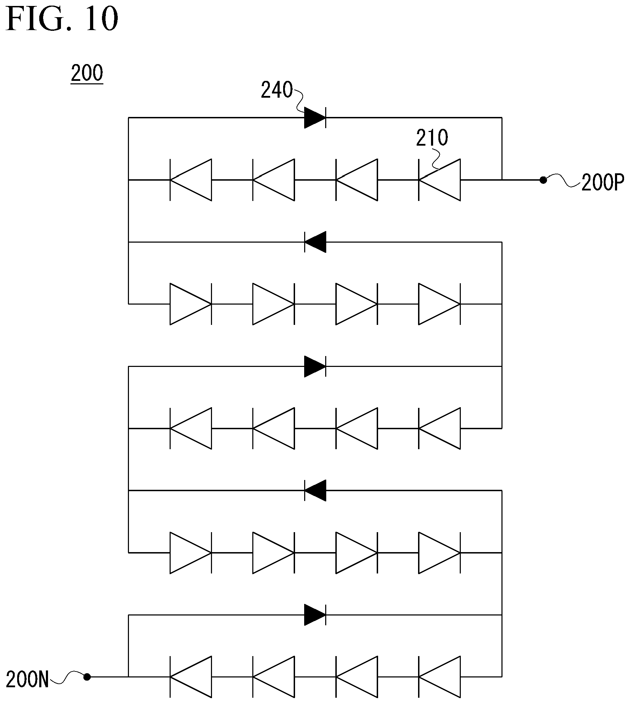

FIG. 10 is an equivalent circuit diagram of the bottom cell module 200. As shown, the bottom cell module 200 has a circuit configuration in which bottom cells are connected in a one-in-parallel, 20-in-series configuration.

In the solar cell 1 configured in this manner, the top cell module 100 has a larger number of parallel connections than the bottom cell module 200 and the output current of the top cell module 100 is larger than the output current of one top cell 110. Here, if the number of parallel connections of the top cell modules 100 and the number of parallel connections of the bottom cell module 200 are the same, the output current of the top cell module 100 is 1/α of the output current of the bottom cell module 200 due to the current ratio described above and the currents of the top cell module 100 and the bottom cell module 200 do not match and therefore it is difficult to connect the top cell modules 100 and the bottom cell module 200 in series. In view of this, the solar cell 1 of the embodiment increases the number of parallel connections of the top cell modules 100, such that it is possible to eliminate the difference between the output current of the top cell module 100 and the output current of the bottom cell module 200, approaching a current-matched state. As a result, the top cell module 100 and the bottom cell module 200 can be connected in series and power generated by the top cell module 100 and the bottom cell module 200 can be efficiently used. The weight of the solar cell 1 can also be reduced since the number of positive terminals 1P and the number of negative terminals 1N of the solar cell 1 can each be reduced to one.

Although it is desirable that a quotient β obtained by dividing the number of parallel connections of the top cell modules 100 by the number of parallel connections of the bottom cell modules 200 match the characteristic value α, β may be slightly different from α as long as β is closer to α than to 1 (that is, the numbers of parallel connections serve to achieve current matching) and does not exceed an upper limit (for example, about 1.5×α). Since β=4 in the embodiment illustrated above, the materials of the top cells 110 and the bottom cells 210 may be selected such that α=4.

According to the first embodiment described above, the connection mode of the plurality of top cells 110 and the connection mode of the plurality of bottom cells 210 (that is, the quotient β) are set to match the current ratio α between the top cells 110 and the bottom cells 210 and thus power generated by the top cell module and the bottom cell module can be efficiently used.

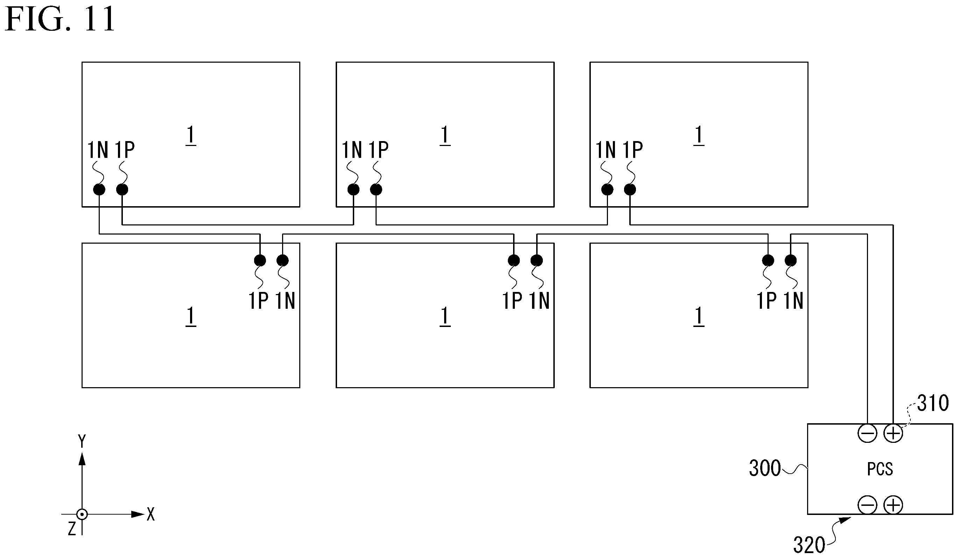

The solar cells 1 having such a configuration are used, for example, in the following manner. FIG. 11 is a configuration diagram of a solar cell system according to the first embodiment. Each solar cell 1 is geometrically configured such that the positive terminal 100P of the top cell module 100 (that is, the positive terminal 1P of the solar cell 1) and the negative terminal 200N of the bottom cell module 200 (that is, the negative terminal 1N of the solar cell 1) are arranged at one corner of the solar cell 1. In FIG. 11, if an upper solar cell 1 is rotated 180 degrees about the Z-axis, it will match a lower solar cell 1 and thus both are equivalent.

As shown in FIG. 11, the solar cells 1 are arranged adjacent to each other and the positive terminal 1P and the negative terminal 1N of solar cells 1 adjacent to each other in the X direction are connected.

Such a configuration produces a solar cell system in which a plurality of solar cells 1 are connected in series. Power generated by the solar cell system is input to an input terminal 310 of a power conditioning system (PCS) 300 and output through an output terminal 320.

According to the first embodiment described above, it is possible to efficiently arrange a plurality of solar cells 1 in series with a reduced wiring length, compared to the solar cell system of the related art in which four-terminal modules are connected.

### Second embodiment

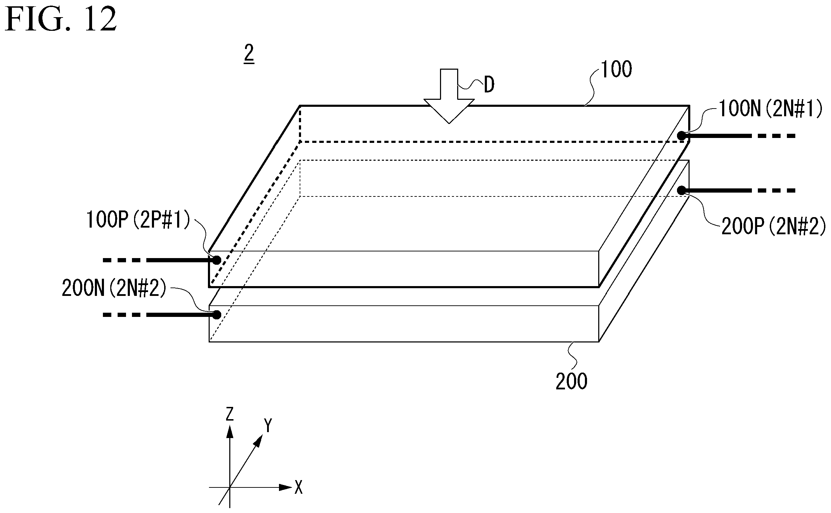

A second embodiment will be described below. FIG. 12 is a configuration diagram of a solar cell 2 of the second embodiment. The solar cell 2 differs from the solar cell 1 of the first embodiment in that a negative terminal 100N of a top cell module 100 is not connected to a positive terminal 200P of a bottom cell module 200, a positive terminal 100P of the top cell module 100 doubles as a first positive terminal 2P#1 of the solar cell 2, the negative terminal 100N of the top cell module 100 doubles as a first negative terminal 2N#1 of the solar cell 2, the positive terminal 200P of the bottom cell module 200 doubles as a second positive terminal 2P#1 of the solar cell 2, and a negative terminal 200N of the bottom cell module 200 doubles as a second negative terminal 2N#1 of the solar cell 2. That is, in the solar cell 2 of the second embodiment, the top cell module 100 and the bottom cell module 200 function as independent solar cells. The internal configurations of the top cell module 100 and the bottom cell module 200 are the same as those of the first embodiment and description thereof will be omitted.

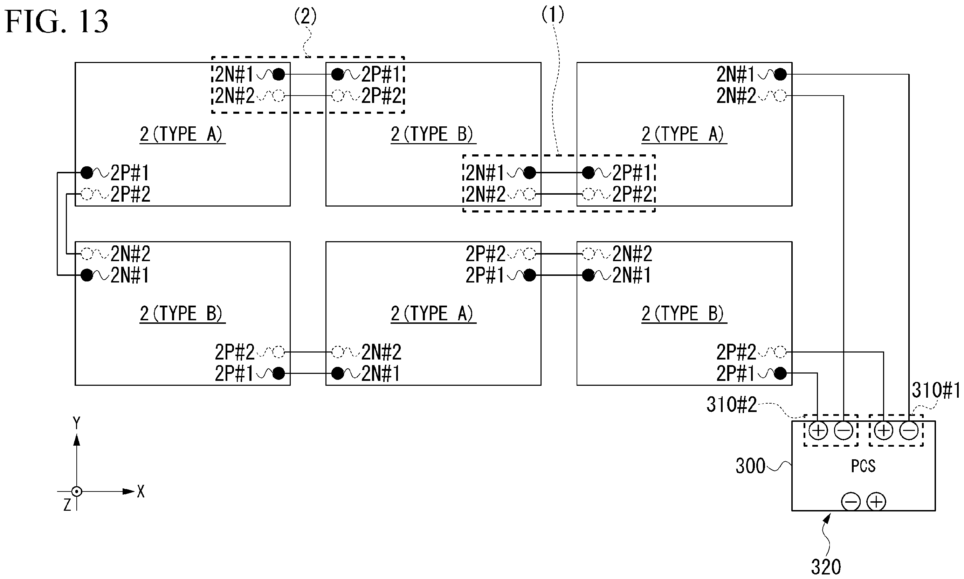

The solar cells 2 having such a configuration are used, for example, in the following manner. FIG. 13 is a configuration diagram of a solar cell system according to the second embodiment. Each solar cell 2 can be formed as one of two types of geometric configurations, type A and type B. The solar cell 2 (of type A) is that in which the positive terminal 100P of the top cell module 100 (that is, the first positive terminal 2P#1 of the solar cell 2) is present at a first corner when viewed from the light incident side (from the positive Z side). The first corner is the upper right corner or the lower left corner, and if the solar cell 2 is rotated 180 degrees about the Z-axis, there is no distinction between the upper right corner and the lower left corner and thus these corners are equivalent. The solar cell 2 (of type B) is that in which the positive terminal 100P of the top cell module 100 (that is, the first positive terminal 2P#1 of the solar cell 2) is present at a second corner when viewed from the light incident side (from the positive Z side). The second corner is a corner adjacent to the first corner, which is either lower right or upper left. If the solar cell 2 has a square shape, there is no difference between the types A and B, but this is not the case. The solar cell 2 (of type A) is an example of a "solar cell of a first type," and the solar cell 2 (of type B) is an example of a "solar cell of a second type."

As shown in FIG. 13, the solar cells 2 (of type A) and the solar cells 2 (of type B) are alternately arranged in the arrangement direction (the X direction), and at the connection point between a solar cell 2 (of type A) and a solar cell 2 (of type B) that are adjacent to each other, the first positive terminal 2P#1 of the solar cell 2 (of type A) and 2N#1 of the solar cell 2 (of type B) are connected and 2P#2 of the solar cell 2 (of type A) and 2N#2 of the solar cell 2 (of type B) are connected (see (1) in FIG. 13) or alternatively 2N#1 of the solar cell 2 (of type A) and 2P#1 of the solar cell 2 (of type B) are connected and 2N#2 of the solar cell 2 (of type A) and the second positive terminal 2P#2 of the solar cell 2 (of type B) are connected (see (2) in FIG. 13)

Such a configuration produces a front cell solar cell system in which top cell modules 100 of a plurality of solar cells 2 are connected in series and a bottom cell solar cell system in which bottom cell modules 200 of a plurality of solar cells 2 are connected in series. Power generated by the front cell solar cell system and power generated by the bottom cell solar cell system are input respectively to a first input terminal 310#1 and a second input terminal 310#2 of a power conditioning system (PCS) 300, processing such as current matching is performed in the PCS 300, and integrated power is output through an output terminal 320.

According to the second embodiment described above, in addition to achieving the same advantages as those of the first embodiment, by using solar cells of two types as illustrated in FIG. 13, it is possible to efficiently arrange a plurality of solar cells 2 in series with a reduced wiring length, compared to the case of using only cells of one type.

While the arrangements of cell interconnectors 230 and 235 which connect bottom cells 210 that are adjacent in the Y direction are schematically shown in the configurations of FIGS. 6 and 8, they may also actually be arranged to protrude outside of bottom cells 210 in the X direction.

### Regarding arrangement of electrodes in top cell module 100

The arrangement of electrodes of the solar cell of the embodiment will be described in more detail below. As previously described, the bottom cell module 200 includes a number of bottom cells 210 equal to the number of top cells 110. The plurality of top cells 110 includes a plurality of top cells 110 arranged in a first direction (the X direction) and the plurality of top cells 110 and the plurality of bottom cells 210 are arranged to face each other in a one-to-one correspondence in plan view. In the example of FIG. 2, a set of top cells 110 arranged in the X direction such as the top cells 110-1 to 110-4 corresponds to the "plurality of top cells 110 arranged in the first direction (the X direction)."

Here, an electrode connecting the plurality of top cells 110 is positioned such that the electrode does not overlap the bottom cells 210 in plan view. Accordingly, it is possible to limit a decrease in the amount of power generated by the bottom cells. This will be explained below.

### Regarding Y direction

Each of the plurality of top cells 110 has a portion that protrudes relative to a bottom cell 210 facing the top cell (for example, a bottom cell 210 having the same reference numeral after the hyphen) among the plurality of bottom cells 210 in a second direction (the Y direction) orthogonal to the first direction (the X direction) in plan view, and the protruding portion is provided with a first electrode that connects the plurality of top cells 110 arranged in the first direction in parallel. "In plan view" indicates, for example, "when viewed in the Z direction." "In plan view" can be rephrased as "when viewed in the direction D of incidence of assumed light" and can also be rephrased as "when viewed in a direction perpendicular to a widest planar portion of the solar cell 1 or 2." "Protruding" indicates that ends of the top cell 110 are present outside ends (outer edge lines) of the bottom cell 210 on both sides thereof in the Y direction. The first electrode includes a positive-side cell interconnector 120P and a negative-side cell interconnector 120N.

### Regarding X direction

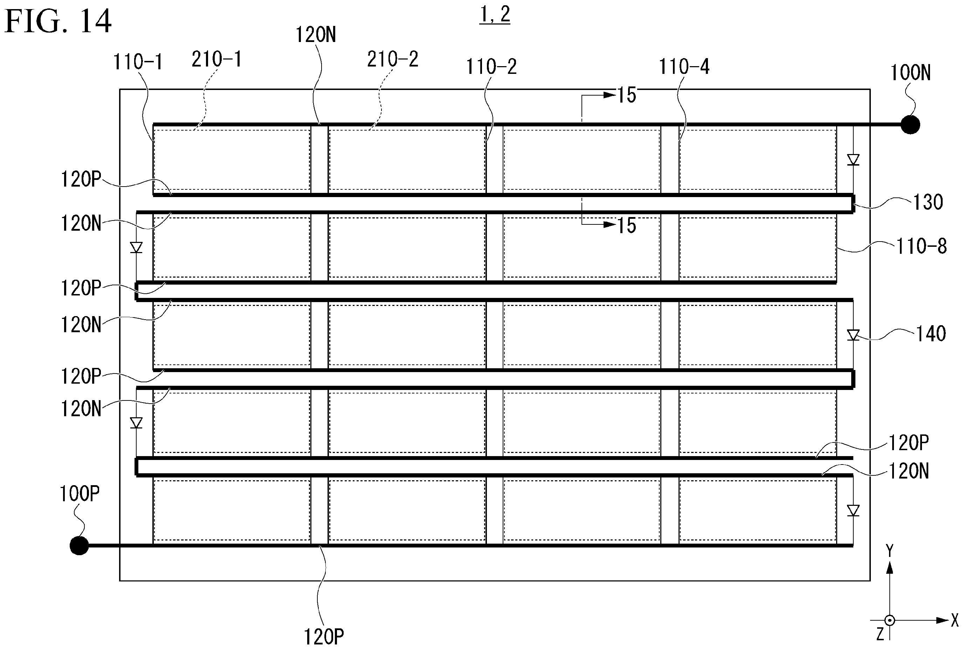

A second electrode (a string connector 130) connecting the first electrodes protrudes outside of the plurality of top cells 110 in the first direction (the X direction) in plan view. That is, the first electrodes extend, in the X direction, to the outside of the ends (outer edge lines) of top cells 110 positioned at both ends among the top cells 110 arranged in the X direction and a second electrode connects ends of the first electrodes. For example, in the example of FIG. 14 which will be described later, a positive-side cell interconnector 120P extends beyond an X-direction end of a top cell 110-4, a negative-side cell interconnector 120N extends beyond an X-direction end of a top cell 110-8, and a string connector 130 connects tips of the cell interconnectors. The same applies to other locations. With such a configuration, an electrode (including at least a first electrode and may include a second electrode) connecting the plurality of top cells 110 is positioned such that the electrode does not overlap the bottom cells 210 in plan view.

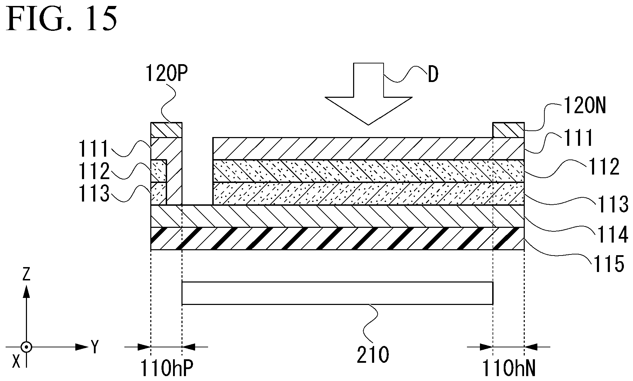

FIG. 14 is a plan view of the solar cell 1 or 2. FIG. 15 is a cross-sectional view along line 15-15 of FIG. 14. In FIGS. 14 and 15, the configuration illustrated in FIG. 7 and the configuration illustrated in FIG. 9 are not distinguished and the cell interconnectors 230 and the cell interconnectors 235 are omitted. The dimensions and scale are not as shown in FIGS. 14 and 15 and may be changed arbitrarily. Here, a supplementary description will be given of the material or the like of each component. The n-compound layer 112 is a semiconductor that forms a pn junction with a light absorbing layer, and in the case of cuprous oxide, an oxide semiconductor is used as the n-compound layer 112. The n-compound layer 112 preferably has a high transmittance. The p-light absorbing layer 113 is a light absorbing layer of the solar cell and preferably has a high transmittance in order to allow the bottom cell 210 to transmit light of wavelengths other than those absorbed by the light absorbing layer. For example, cuprous oxide Cu₂O is used as the p-light absorbing layer 113. Although the hatching of the substrate 115 corresponds to a "resin," the substrate 115 may be glass as described above. Each of the cell interconnectors 120N and 120P is, for example, a solder-plated copper wire, a conductive tape, a combination of a conductive adhesive and a copper foil, or a copper foil with a resin or the like adhered to one side thereof. The conductive tape is, for example, a combination of a copper foil plated with Sn or the like and a resin-based adhesive.

As shown in FIG. 15, the top cell 110 is provided with protruding portions 110hP and 110hN that protrude outside of the ends of the bottom cell 210 in the Y direction, the positive-side cell interconnector 120P is arranged to be received in the protruding portion 110hP, and the negative-side cell interconnector 120N is arranged to be received in the protruding portion 110hN. The width of each of the protruding portions 110hP and 110hN is, for example, approximately 0 to 10 mm, more preferably approximately 0 to 3 mm. With such a configuration, the power generation area of the top cell 110 and the power generation area of the bottom cell 210 substantially match. In FIG. 4, the positive-side cell interconnector 120P is arranged in contact with the p-electrode 114, but in FIG. 15, the positive-side cell interconnector 120P is arranged in contact with an isolated n-electrode 111 (which is to be semantically called a p-electrode) which is provided on the p-electrode 114 and arranged apart from the main laminated structure in the Y direction. In this case, a current flows passes through the n-electrode 111, the n-compound layer 112, the p-light absorbing layer 113, and the p-electrode 114, starting from the negative-side cell interconnector 120N, and further passes through the isolated n-electrode 111 and reaches the positive-side cell interconnector 120P. The portion between the protruding portions 110hP and 110hN may have a structure that is scribed in the X direction at a plurality of locations.

With the configuration illustrated here, an electrode connecting the plurality of top cells 110 is positioned such that the electrode does not overlap the bottom cells 210 in plan view.

According to at least one embodiment described above, a top cell module 100 configured to generate power by photoelectrically converting incident light and allow part of the incident light to pass through the top cell module 100 and a bottom cell module 200 laminated to the top cell module 100, the bottom cell module 200 being configured to generate power by photoelectrically converting light that has passed through the top cell module 100, are provided, wherein the top cell module 100 includes a plurality of top cells 110 that are connected in series, in parallel, or in a combination of series and parallel, the bottom cell module 200 includes a plurality of bottom cells 210 that are connected in series, in parallel, or in a combination of series and parallel, the number of the bottom cells 210 being equal to the number of the top cells 110, and an electrode connecting the plurality of top cells 110 is positioned such that the electrode does not overlap the bottom cells 210 in plan view. Accordingly, it is possible to limit a decrease in the amount of power generated by the bottom cells 210 due to the shadow of the electrode on the bottom cells 210.

The solar cell or the solar cell system of each embodiment can efficiently generate power in a small space, such that it can be suitably mounted at various locations with many restrictions such as the wing surfaces of aircrafts.

Although some embodiments of the present invention have been described, these embodiments have been presented by way of example and are not intended to limit the scope of the invention. These embodiments can be implemented in various other forms, and various omissions, substitutions, and changes can be made without departing from the spirit of the invention. These embodiments and modifications thereof are included in the scope or spirit of the invention as well as in the scope of the invention described in the claims and their equivalents.

## Claims

1. A solar cell comprising:
a top cell module configured to generate power by photoelectrically converting incident light and allow part of the incident light to pass through the top cell module; and
a bottom cell module laminated to the top cell module, the bottom cell module being configured to generate power by photoelectrically converting light that has passed through the top cell module,
wherein the top cell module includes a plurality of top cells that are connected in series, in parallel, or in a combination of series and parallel,
the bottom cell module includes a plurality of bottom cells that are connected in series, in parallel, or in a combination of series and parallel, the number of the bottom cells being equal to the number of the top cells, and
an electrode connecting the plurality of top cells is positioned such that the electrode does not overlap the bottom cells in plan view.

2. The solar cell according to claim 1, wherein the plurality of top cells include a plurality of top cells arranged in a first direction,
the plurality of top cells and the plurality of bottom cells are arranged to face each other in a one-to-one correspondence in plan view,
each of the plurality of top cells has a portion that protrudes relative to a bottom cell facing the top cell among the plurality of bottom cells in a second direction orthogonal to the first direction in plan view, and
the protruding portion is provided with a first electrode that connects the plurality of top cells arranged in the first direction in parallel.

3. The solar cell according to claim 2, wherein a second electrode connecting the first electrodes protrudes outside of the plurality of top cells in the first direction in plan view.

4. The solar cell according to claim 1, wherein a connection mode of the plurality of top cells and a connection mode of the plurality of bottom cells are set to match a current ratio between the top cells and the bottom cells.

5. The solar cell according to claim 4, wherein a positive terminal of the top cell module is a positive terminal of the solar cell,
a negative terminal of the bottom cell module is a negative terminal of the solar cell, and
a negative terminal of the top cell module is connected to a positive terminal of the bottom cell module.

6. A solar cell system comprising a plurality of solar cells according to claim 5,
wherein the plurality of solar cells are arranged such that the plurality of solar cells are adjacent to each other in at least one direction, and
at a connection point of the plurality of solar cells adjacent to each other, the positive terminal of one of the plurality of solar cells adjacent to each other in the at least one direction and the negative terminal of another of the plurality of solar cells adjacent to each other are connected.

7. The solar cell according to claim 4, wherein a positive terminal of the top cell module is a first positive terminal of the solar cell,
a negative terminal of the top cell module is a first negative terminal of the solar cell,
a positive terminal of the bottom cell module is a second positive terminal of the solar cell,
a negative terminal of the bottom cell module is a second negative terminal of the solar cell.

8. A solar cell system comprising one or more solar cells of a first type in which the positive terminal of the top cell module is present at a first corner when viewed from a light incident side and one or more solar cells of a second type in which the positive terminal of the top cell module is present at a second corner adjacent to the first corner when viewed from a light incident side, the solar cells being a plurality of solar cells according to claim 7,
wherein the solar cells of the first type and the solar cells of the second type are arranged alternately in an arrangement direction, and
at a connection point of a solar cell of the first type and a solar cell of the second type adjacent to each other,
the first positive terminal of the solar cell of the first type and the first negative terminal of the solar cell of the second type are connected and the second positive terminal of the solar cell of the first type and the second negative terminal of the solar cell of the second type are connected, or alternatively
the first negative terminal of the solar cell of the first type and the first positive terminal of the solar cell of the second type are connected and the second negative terminal of the solar cell of the first type and the second positive terminal of the solar cell of the second type are connected.
